# EUROPEAN PATENT APPLICATION

(11) **EP 4 270 453 A1**
(43) Date of publication of application: **01.11.2023**
(21) Application number: 22170459.6
(22) Date of filing: 28.04.2022
(51) Int. Cl.: H01L 21/56, H01L 23/24, H01L 23/31, H01L 21/54

(54) **METHOD FOR FABRICATING A POWER SEMICONDUCTOR MODULE COMPRISING AN ENCAPSULATION MATERIAL WITH A HIGH THERMOSTABILITY AND POWER SEMICONDUCTOR MODULE**

(71) Applicant: Infineon Technologies AG, 85579 Neubiberg (DE)
(72) Inventor: GOLDAMMER, Martin, 59494 Soest (DE); BOENIG, Guido, 59581 Warstein (DE); EHLERS, Carsten, 41066 Mönchengladbach (DE)
(74) Representative: Lambsdorff & Lange Patentanwälte Partnerschaft mbB

(57) **Abstract**

A method for fabricating a power semiconductor module comprises: arranging a power semiconductor die on a power substrate, electrically connecting the power semiconductor die to the power substrate using an electrical connector, covering at least selective portions of the power semiconductor die and the electrical connector with a first encapsulation material, enclosing the power semiconductor die and the power substrate with a housing, and arranging a second encapsulation material on the first encapsulation material, such that the first and second encapsulation materials at least partially fill an interior volume formed by the housing, wherein the first encapsulation material exhibits a higher thermostability than the second encapsulation material.

## Description

### TECHNICAL FIELD

This disclosure relates in general to a method for fabricating a power semiconductor module comprising an encapsulation material with a high thermostability, as well as to such a power semiconductor module.

### BACKGROUND

Power semiconductor modules may comprise an encapsulation material configured to encapsulate and protect sensitive components like power semiconductor dies and electrical connectors (e.g. bond wires, ribbons or contact clips). Technological progress has led to the development of power semiconductor modules for voltage classes of e.g. 6.5kV and higher, as well as to an increased power density within the power semiconductor modules. This also causes increased temperature peaks during operation, for example temperature peaks of 200°C or more, within the power semiconductor modules. Common encapsulation materials may not be configured to handle such extreme temperatures and therefore it may be necessary to use high performance encapsulation materials. However, such high performance encapsulation materials may be comparatively costly and may significantly increase the overall costs of the power semiconductor module. Improved methods for fabricating a power semiconductor module as well as improved power semiconductor modules may help to solve these and other problems.

The problem on which the invention is based is solved by the features of the independent claims. Further advantageous examples are described in the dependent claims.

### SUMMARY

Various aspects pertain to a method for fabricating a power semiconductor module, the method comprising: arranging a power semiconductor die on a power substrate, electrically connecting the power semiconductor die to the power substrate using an electrical connector, covering at least selective portions of the power semiconductor die and the electrical connector with a first encapsulation material, enclosing the power semiconductor die and the power substrate with a housing, and arranging a second encapsulation material on the first encapsulation material, such that the first and second encapsulation materials at least partially fill an interior volume formed by the housing, wherein the first encapsulation material exhibits a higher thermostability than the second encapsulation material.

Various aspects pertain to a power semiconductor module, comprising: a power semiconductor die arranged on a power substrate, an electrical connector electrically connecting the power semiconductor die to the power substrate, a first encapsulation material covering at least selective portions of the power semiconductor die and the electrical connector, a housing enclosing the power semiconductor die and the power substrate, wherein an interior volume formed by the housing is divided by dividing walls into at least a first compartment and a second compartment, and a second encapsulation material arranged on the first encapsulation material, such that the first and second encapsulation materials at least partially fill the interior volume, wherein the first encapsulation material exhibits a higher thermostability than the second encapsulation material, and wherein the first encapsulation material is arranged within the first compartment but not within the second compartment.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figures 1A to 1F each show a sectional view of a power semiconductor module comprising a first and a second encapsulation material in various stages of fabrication, according to an exemplary method for fabricating power semiconductor modules.
Figures 2A and 2B show a process of depositing a precursor of an encapsulation material on a semiconductor die (Fig. 2A) and a process of curing the precursor in order to fabricate the encapsulation material (Fig. 2B).
Figure 3 shows a process of depositing a liquid precursor of an encapsulation material, wherein a plurality of lines of the liquid precursor are dispensed on top of each other.
Figure 4 shows a process of depositing a precursor of an encapsulation material, wherein a temporary frame is used to keep the precursor in place.
Figures 5A and 5B show a plan view (Fig. 5A) and a sectional view (Fig. 5B) of a further exemplary power semiconductor module.
Figure 6 is a flow chart of an exemplary method for fabricating power semiconductor modules.

### DETAILED DESCRIPTION

In the following detailed description, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only. It is to be understood that other examples may be utilized and structural or logical changes may be made without departing from the scope of the present invention.

In addition, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other. Also, the term "exemplary" is merely meant as an example, rather than the best or optimal.

An efficient method for fabricating power semiconductor modules as well as efficient power semiconductor modules may for example reduce material consumption, ohmic losses, chemical waste etc. and may thus enable energy and/or resource savings. Improved methods for fabricating power semiconductor modules, as well as improved power semiconductor modules, as specified in this description, may thus at least indirectly contribute to green technology solutions, i.e. climate-friendly solutions providing a mitigation of energy and/or resource use.

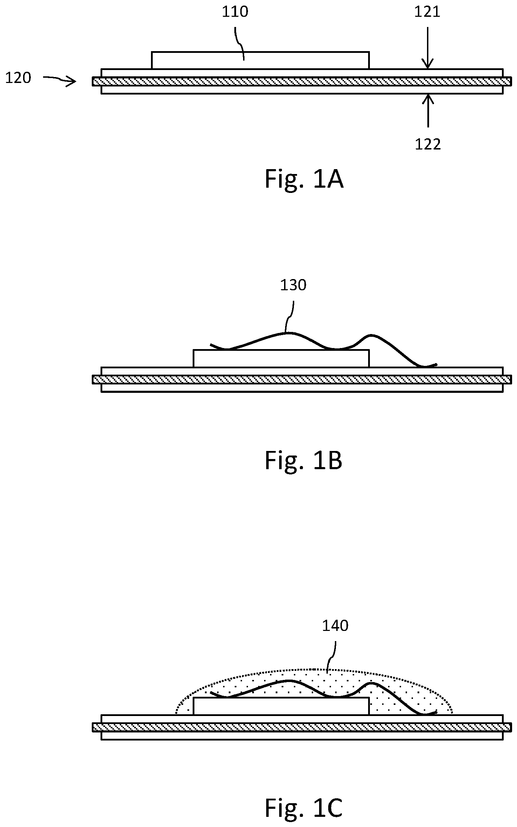

Figures 1A to 1F show a power semiconductor module 100 in various stages of fabrication, according to an exemplary method for fabricating a power semiconductor module.

As shown in Figure 1A, the method comprises a process of arranging a power semiconductor die 110 on a power substrate 120.

The power semiconductor die 110 may for example be a MOSFET, an IGBT, a diode, etc. The power semiconductor die 110 may comprise a first electrode arranged on a lower side, wherein the lower side faces the power substrate 120, and a second electrode arranged on an upper side, wherein the upper side faces away from the power substrate 120. The first and second electrodes may for example be power electrodes of the power semiconductor die 110.

Arranging the power semiconductor die 110 on the power substrate 120 may e.g. comprise soldering, sintering or gluing the power semiconductor die 110 onto the power substrate 120. In the case that the power semiconductor die 110 comprises a first electrode on the lower side, this may also comprise electrically coupling the first electrode to the power substrate 120.

According to an example, more than one power semiconductor die 110 is arranged on the power substrate 120. The more than one power semiconductor dies 110 may be of the same type or the more than one power semiconductor dies 110 may be different types of dies.

The power substrate 120 may for example be a substrate of the type DCB (direct copper bonded), DAB (direct aluminum bonded), AMB (active metal brazed), etc. The power substrate 120 may comprise two electrically conductive layers separated from each other by an electrically isolating layer.

The power substrate 120 may comprise a first side 121 and an opposite second side 122. The power semiconductor die(s) 110 may for example be arranged on the first side 121. The second side 122 may for example be arranged on a baseplate. According to another example, no baseplate is arranged on the second side 122.

As shown in Figure 1B, the power semiconductor die 110 is electrically connected to the power substrate 120 using an electrical connector 130. This may in particular comprise electrically connecting a second electrode arranged on the upper side of the power semiconductor die 110 to the power substrate 120 via the electrical connector 130.

According to an example, the power semiconductor module 100 comprises more than one power semiconductor die 110 and at least one electrical connector 130 is used to electrically couple the power semiconductor dies 110 to each other.

Electrically connecting the power semiconductor die 110 to the power substrate 120 via the electrical connector 130 may comprise soldering, sintering or gluing the electrical connector 130 to at least one electrode, e.g. a power electrode, of the power semiconductor die 110.

The electrical connector 130 may be any suitable type of connector, e.g. a bond wire, a ribbon or a contact clip. The electrical connector 130 may for example comprise or consist of Al or Cu. The power semiconductor module 100 may also comprise more than one electrical connector 130. The more than one electrical connectors 130 may be of the same type or the more than one electrical connectors 130 may be different types of connectors, e.g. a bond wire and a contact clip.

As shown in Figure 1C, at least selective portions of the power semiconductor die 110 and the electrical connector 130 are covered with a first encapsulation material 140.

According to an example, selective portions of the power semiconductor die 110 are covered with the first encapsulation material 140 while other portions of the power semiconductor die 110 are left exposed from the first encapsulation material 140. According to another example, the whole power semiconductor die 110 is covered with the first encapsulation material 140. According to an example, selective portions of the electrical connector 130 are covered with the first encapsulation material 140 while other portions of the electrical connector 130 are left exposed from the first encapsulation material 140. According to another example, the whole electrical connector 130 is covered with the first encapsulation material 140. Additionally or alternatively, the first encapsulation material 140 may be used to cover selective portions of the power substrate 120 while other portions of the power substrate 120 are left exposed from the first encapsulation material 140.

Selective portions of the power semiconductor die 110 that are covered with the first encapsulation material 140 may for example comprise power electrodes of the power semiconductor die 110 and/or generally any part of the power semiconductor die 110 which heats up to particularly high temperatures during operation of the power semiconductor module 100.

Selective portions of the electrical connector 130 that are covered with the first encapsulation material 140 may for example comprise portions that are close to a power electrode of the power semiconductor die 110 and/or portions that have a particularly high current density and/or portions that heat up to particularly high temperatures during operation of the power semiconductor module 100.

The first encapsulation material 140 may for example comprise or consist of a material which exhibits particularly high temperature stability. For example, the first encapsulation material 140 may exhibit less than 2% weight loss at 300°C. The first encapsulation material 140 may for example comprise or consist of a mold compound, in particular an inorganic mold compound. The first encapsulation material 140 may comprise or consist of a silicone resin.

According to an example, the first encapsulation material 140 comprises filler particles, for example filler particles selected from the group containing Al₂O₃, BN, AlN, Si₃N₄, diamond, or any other thermally conductive particles. The filler particles may for example account for 20% or more, 40% or more, 60% or more, or 80% or more of the total volume of the first encapsulation material 140.

According to an example, the power semiconductor die 110 and the electrical connector 130 (or at least the selective portions thereof) may be covered with the first encapsulation material 140 before the power substrate 120 is arranged on a baseplate. In this manner, the power semiconductor die 110 and the electrical connector 130 may be protected from environmental influences at an early stage of fabrication of the power semiconductor module 100. According to another example, the first encapsulation material 140 is applied after the power substrate 120 has been arranged on a baseplate.

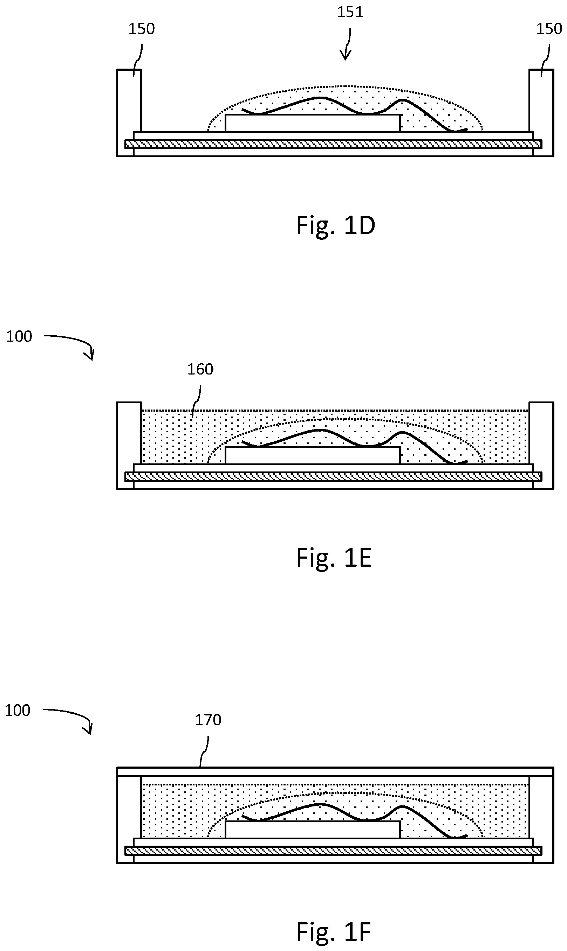

As shown in Figure 1D, the power semiconductor die 110 and the power substrate 120 are enclosed with a housing 150. The housing 150 may define an interior volume 151, wherein the power semiconductor die 110 and the first encapsulation material 140 are arranged within the interior volume 151.

The housing 150 may be arranged around or at least partially around lateral sides of the power substrate 120, wherein the lateral sides connect the first and second sides 121, 122 of the power substrate 120. The power semiconductor module 100 may comprise external contacts (in particular external power contacts) which may be exposed from the housing 150. The external contacts may for example extend out of the housing 150 at the lateral sides of the power substrate 120 or close to the lateral sides.

The housing 150 may for example comprise or consist of a frame, in particular a plastic frame. The housing 150 may be joined to the power substrate 120 or the housing 150 may be joined to a baseplate, wherein the power substrate 120 is arranged on the baseplate. Joining the housing 150 to the power substrate 120 or to the baseplate may for example be done by clipping, screwing, clamping or gluing.

The housing 150 may be provided after the first encapsulation material 140 has been provided. However, it is also possible that the housing 150 is provided prior to covering at least the selective portions of the power semiconductor die 110 and the electrical connector 130 with the first encapsulation.

As shown in Figure 1E, a second encapsulation material 160 is arranged on the first encapsulation material 140. The first and second encapsulation materials 140, 160 at least partially fill the interior volume 151 formed by the housing 150. Furthermore, the first encapsulation material 140 exhibits a higher thermostability than the second encapsulation material 160. This may mean that the first encapsulation material 140 is more resistant to irreversible changes in its chemical and/or physical structure at high temperatures than the second encapsulation material 160. The first encapsulation material 140 may for example exhibit less weight loss and/or less shrinkage at elevated temperatures than the second encapsulation material 160.

The second encapsulation material 160 may for example comprise or consist of a suitable organic material. The second encapsulation material 160 may for example comprise or consist of a potting material, a polymer, a silicone gel, epoxy resin, acrylate, etc. The first and second encapsulation materials 130, 160 may in particular be different materials or the first and second encapsulation materials 130, 160 may have different material compositions.

The second encapsulation material 160 may be a comparatively cheap material while the first encapsulation material 140 may be a comparatively expensive material. The second encapsulation material 160 may e.g. be deposited on parts of the power semiconductor module 100 which during operation do not heat up above a critical temperature, e.g. a critical temperature of about 150°C or 175°C or 200°C or more. The first encapsulation material 140 on the other hand may be deposited on those parts of the power semiconductor module 100 which during operation do heat up to a temperature above the critical temperature.

In the above-described manner, the amount of the comparatively expensive first encapsulation material 140 used in the power semiconductor module 100 may be reduced without impairing thermostability of the module. This may for example reduce the costs of the power semiconductor module 100.

The second encapsulation material 160 may for example completely cover the first encapsulation material 140 or the second encapsulation material 160 may only partially cover the first encapsulation material 140. The second encapsulation material 160 may be arranged directly on at least a portion of the first side 121 of the power substrate 120. The second encapsulation material 160 may be in direct contact with the housing 150. The first encapsulation material 140 may or may not be in direct contact with the housing 150, depending on the location of the selective portions of the power semiconductor die 110 and the electrical connector 130 which are covered with the first encapsulation material 140.

According to an example, arranging the second encapsulation material 160 on the first encapsulation material 140 comprises depositing, in particular dispensing, the second encapsulation material into the interior volume 151.

The first and second encapsulation materials 140, 160 may partially fill the interior volume 151 or the first and second encapsulation materials 140, 160 may completely fill the interior volume 151. A volume of the second encapsulation material 160 may for example be 1.5 times as large, twice as large, three times as large, four times as large, or even larger than a volume of the first encapsulation material 140.

As shown in Figure 1F, fabricating the power semiconductor module 100 may optionally comprise arranging a lid 170 on the housing 150, wherein the lid 170 may be configured to close off the interior volume 151.

According to an example, the power semiconductor module 100 may comprise further external contacts which are exposed from the lid 170. These further external contacts may for example be sensing contacts and/or control contacts. Furthermore, a board comprising one or more logic dies may be arranged over the lid 170, wherein the board is electrically coupled to the further external contacts. The one or more logic dies may be configured to control the one or more power semiconductor dies 110.

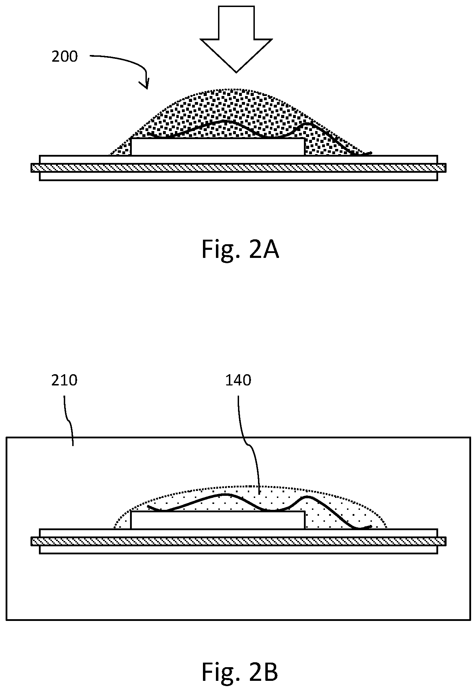

With respect to Figures 2A to 5B, different methods of covering at least the selective portions of the power semiconductor die 110 and the electrical connector 130 with the first encapsulation material 140 are shown.

As shown in Figure 2A, a liquid or powdery precursor 200 of the first encapsulation material 140 is dispensed over at least the selective portions of the power semiconductor die 110 and the electrical connector 130.

In the case that a liquid precursor 200 is used, the liquid precursor 200 may for example be a thixotropic material and/or a material with a relatively high viscosity. In this way, the precursor 200 does not dissolve from the parts of the power semiconductor module 100 it was dispensed over.

As shown in Figure 2B, the precursor 200 is cured in order to fabricate the first encapsulation material 140. Curing the precursor 200 may comprise applying heat and/or radiation to the precursor 200. For example, an oven 210 may be used to cure the precursor 200. Alternatively or additionally, a UV lamp, an IR lamp, a hot plate or any other suitable means for curing the precursor 200 may be used.

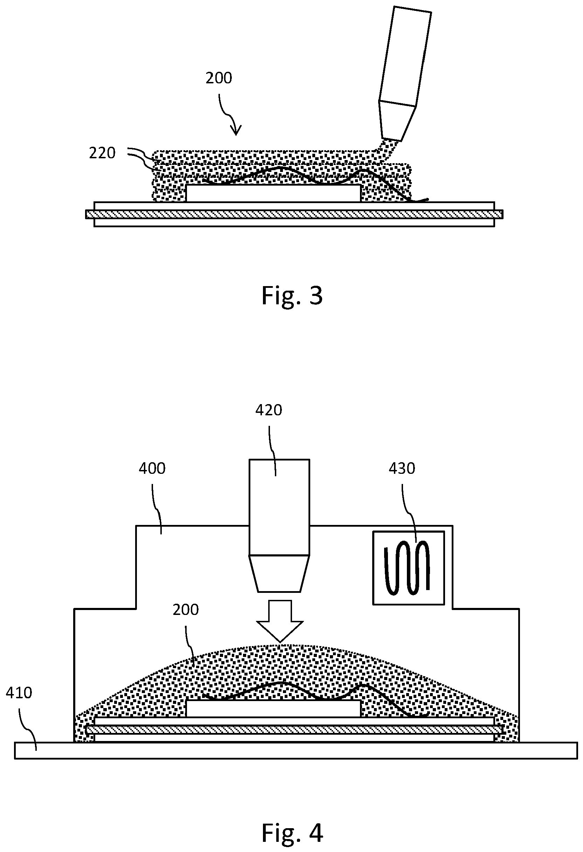

As shown in Figure 3, a liquid precursor 200 may be deposited by dispensing a plurality of lines 220 of the liquid precursor 200 on top of each other. This way of dispensing the liquid precursor 200 may be akin to a 3D printing process. The liquid precursor 200 may have a high viscosity such that it does not dissolve prior to curing.

According to an example, individual lines 220 of the precursor 200 are dispensed on top of each other. According to an example, the plurality of lines 220 is dispensed in a meandering shape or one or more contiguous lines are dispensed in a meandering shape.

As shown in Figure 4, at least the selective portions of the power semiconductor die 110 and at least the selective portions of the electrical connector 130 may be arranged inside a temporary frame 400.

The temporary frame 400 may be part of a dispensing equipment. The temporary frame 400 may be configured to act as a holder for holding a liquid or powdery precursor 200 until the precursor 200 has been cured. A bottom of the temporary frame 400 may for example be sealed by a temporary carrier 410, in particular a tape, wherein the power substrate 120 is arranged on the temporary carrier 410.

The liquid or powdery precursor 200 of the first encapsulation material 140 may be dispensed into the temporary frame 400 such that the precursor 200 is held in place by the temporary frame 400. In order to dispense the precursor 200, the temporary frame 400 may be equipped with an integrated dispenser 420. In this way, the temporary frame 400 and the dispenser 420 may be placed over the power semiconductor die 110 and the electrical connector 130 in one step. However, it is also possible that the dispensing tool is independent of the temporary frame 400.

As mentioned above, the precursor 200 is cured while the temporary frame 400 is in place. For this purpose, the temporary frame 400 may be equipped with integrated curing means 430 which may e.g. comprise a heater and/or a light source. Again, it is also possible that the curing means are independent of the temporary carrier 400. In addition or alternatively, a hardening agent may be added to the precursor 200 within the frame 400 to facilitate curing.

Once the precursor 200 has been cured (i.e. once the first encapsulation material 140 has been fabricated), the temporary frame 400 may be removed. According to an example, the temporary frame 400 consists of a plurality of parts which may be disassembled in order to remove the temporary frame 400 from the first encapsulation material 140. However, it is also possible that the temporary frame 400 is removed as one part.

Instead of the temporary frame 400 described with respect to Fig. 4, it is also possible to use the housing 150 to hold the precursor 200 in place for the curing process. In other words, the power semiconductor die 110 and the power substrate 120 may be enclosed with the housing 150 and afterwards the precursor 200 may be dispensed into the interior volume 151 and then cured. After the curing process, the housing 150 is not removed like the temporary frame 400 but remains as a part of the power semiconductor module 100.

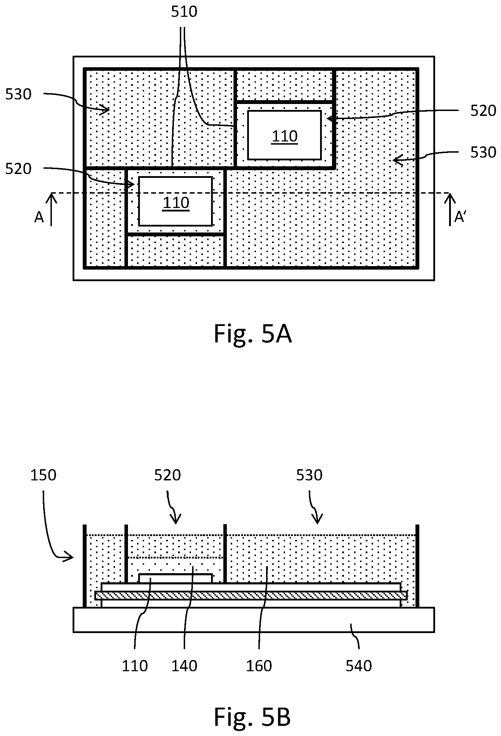

Figure 5A shows a plan view of a further power semiconductor module 500 which may be similar or identical to the power semiconductor module 100, except for the differences described in the following. Figure 5B shows a sectional view along the line A-A'. For simplicity's sake, the electrical connector(s) 130 are not shown in Figs. 5A and 5B.

In particular, the interior volume 151 of the housing 150 of the power semiconductor module 500 is divided by dividing walls 510 into at least a first compartment 520 and a second compartment 530. In the example shown in Fig. 5A, the power semiconductor module 500 comprises more than one first compartments 520 and more than one second compartments 530.

The power semiconductor die(s) 110 of the power semiconductor module 500 may for example be arranged solely within the one or more first compartments 520. Alternatively, at least some of the power semiconductor dies 110 may be arranged within the one or more second compartments 530.

The first encapsulation material 140 is arranged within the one or more first compartments 520 but not within the one or more second compartments 530. The first compartments 520 may be arranged at those portions of the power semiconductor module 500 which have a comparatively higher operating temperature and therefore require the high temperature tolerance of the first encapsulation material 140. The second compartments 530 on the other hand may be arranged at those portions of the power semiconductor module 500 which have a comparatively lower operating temperature and therefore may be encapsulated with the comparatively cheaper second encapsulation material 160.

As shown in Figure 5B, the power semiconductor module 500 may for example comprise a baseplate 540, wherein the power substrate 120 and/or the housing 150 is arranged on the baseplate 540.

According to an example, the first compartment(s) 520 comprise the first encapsulation material 140 but not the second encapsulation material 160. According to another example, the first compartment(s) 520 comprise both the first and second encapsulation materials 140, 160 (this example is shown in Fig. 5B).

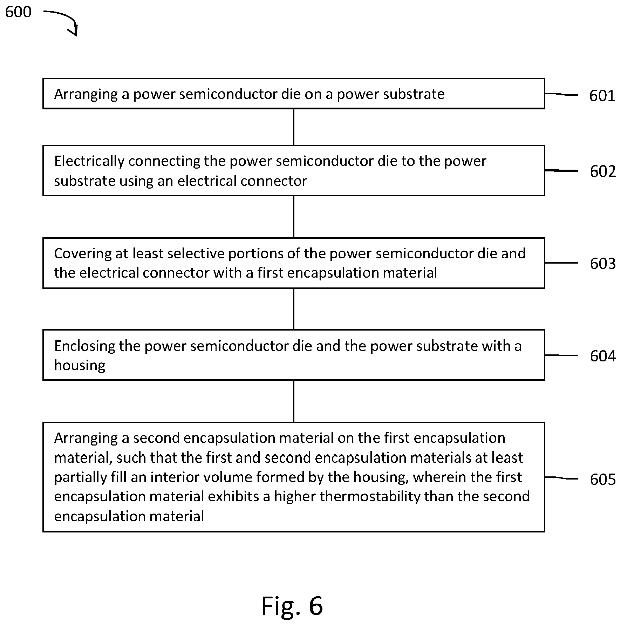

Figure 6 is a flow chart of a method 600 for fabricating a power semiconductor module. The method 600 comprises at 601 an act of arranging a power semiconductor die on a power substrate, at 602 an act of electrically connecting the power semiconductor die to the power substrate using an electrical connector, at 603 an act of covering at least selective portions of the power semiconductor die and the electrical connector with a first encapsulation material, at 604 an act of enclosing the power semiconductor die and the power substrate with a housing, and at 605 an act of arranging a second encapsulation material on the first encapsulation material, such that the first and second encapsulation materials at least partially fill an interior volume formed by the housing, wherein the first encapsulation material exhibits a higher thermostability than the second encapsulation material.

### EXAMPLES

Example 1 is a method for fabricating a power semiconductor module, the method comprising: arranging a power semiconductor die on a power substrate, electrically connecting the power semiconductor die to the power substrate using an electrical connector, covering at least selective portions of the power semiconductor die and the electrical connector with a first encapsulation material, enclosing the power semiconductor die and the power substrate with a housing, and arranging a second encapsulation material on the first encapsulation material, such that the first and second encapsulation materials at least partially fill an interior volume formed by the housing, wherein the first encapsulation material exhibits a higher thermostability than the second encapsulation material.

Example 2 is the method of example 1, wherein covering at least the selective portions of the power semiconductor die and the electrical connector with the first encapsulation material comprises: dispensing a liquid or powdery precursor of the first encapsulation material over at least the selective portions of the power semiconductor die and the electrical connector, and curing the precursor in order to form the first encapsulation material.

Example 3 is the method of example 2, wherein a liquid precursor is used and wherein a plurality of lines of the liquid precursor are dispensed on top of each other.

Example 4 is the method of example 3, wherein the plurality of lines are dispensed in a meandering shape.

Example 5 is the method of one of examples 2 to 4, wherein a liquid precursor is used and wherein the liquid precursor is a thixotropic material.

Example 6 is the method of one of examples 2 to 4, wherein a liquid precursor is used and wherein the liquid precursor is a material with a relatively high viscosity.

Example 7 is the method of example 1, wherein covering at least the selective portions of the power semiconductor die and the electrical connector with the first encapsulation material comprises: arranging at least the selective portions of the power semiconductor die and the electrical connector inside a temporary frame, dispensing a liquid or powdery precursor of the first encapsulation material into the temporary frame, such that the precursor is held in place by the temporary frame, curing the precursor in order to form the first encapsulation material, and removing the temporary frame.

Example 8 is the method of example 7, wherein the temporary frame comprises built in curing means for curing the precursor.

Example 9 is the method of one of examples 1 to 6, wherein the interior volume of the housing is divided by dividing walls into at least a first compartment and a second compartment, wherein the first encapsulation material is arranged within the first compartment but not within the second compartment.

Example 10 is the method of example 9, wherein the first compartment comprises a part of the module with a comparatively higher operating temperature and the second compartment comprises a part of the module with a comparatively lower operating temperature.

Example 11 is the method of one of the preceding examples, wherein the power semiconductor die and the power substrate are enclosed with the housing after at least the selective portions of the power semiconductor die and the electrical connector have been covered with the first encapsulation material.

Example 12 is the method of one of the preceding examples, further comprising: after at least the selective portions of the power semiconductor die and the electrical connector have been covered with the first encapsulation material, arranging the power substrate on a baseplate, and coupling the housing to the baseplate.

Example 13 is the method of one of the preceding examples, wherein the first encapsulation material comprises or consists of an inorganic silicone and filler particles, the filler particles being from the group containing Al₂O₃, BN, AlN, Si₃N₄ and diamond.

Example 14 is a power semiconductor module, comprising: a power semiconductor die arranged on a power substrate, an electrical connector electrically connecting the power semiconductor die to the power substrate, a first encapsulation material covering at least selective portions of the power semiconductor die and the electrical connector, a housing enclosing the power semiconductor die and the power substrate, wherein an interior volume formed by the housing is divided by dividing walls into at least a first compartment and a second compartment, and a second encapsulation material arranged on the first encapsulation material, such that the first and second encapsulation materials at least partially fill the interior volume, wherein the first encapsulation material exhibits a higher thermostability than the second encapsulation material, and wherein the first encapsulation material is arranged within the first compartment but not within the second compartment.

Example 15 is the power semiconductor module of example 14, wherein the first compartment comprises a part of the module with a comparatively higher operating temperature and the second compartment comprises a part of the module with a comparatively lower operating temperature.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A method (600) for fabricating a power semiconductor module (100), the method (600) comprising:
arranging a power semiconductor die (110) on a power substrate (120),
electrically connecting the power semiconductor die (110) to the power substrate (120) using an electrical connector (130),
covering at least selective portions of the power semiconductor die (110) and the electrical connector (130) with a first encapsulation material (140),
enclosing the power semiconductor die (110) and the power substrate (120) with a housing (150), and
arranging a second encapsulation material (160) on the first encapsulation material (140), such that the first and second encapsulation materials (140, 160) at least partially fill an interior volume (151) formed by the housing (150),
wherein the first encapsulation material (140) exhibits a higher thermostability than the second encapsulation material (160).

2. The method (600) of claim 1, wherein covering at least the selective portions of the power semiconductor die (110) and the electrical connector (130) with the first encapsulation material (140) comprises:
dispensing a liquid or powdery precursor (200) of the first encapsulation material (140) over at least the selective portions of the power semiconductor die (110) and the electrical connector (130), and
curing the precursor (200) in order to form the first encapsulation material (140).

3. The method (600) of claim 2, wherein a liquid precursor (200) is used and wherein a plurality of lines (220) of the liquid precursor (200) are dispensed on top of each other.

4. The method (600) of claim 3, wherein the plurality of lines (220) are dispensed in a meandering shape.

5. The method (600) of one of claims 2 to 4, wherein a liquid precursor (200) is used and wherein the liquid precursor (200) is a thixotropic material.

6. The method (600) of one of claims 2 to 4, wherein a liquid precursor (200) is used and wherein the liquid precursor (200) is a material with a relatively high viscosity.

7. The method (600) of claim 1, wherein covering at least the selective portions of the power semiconductor die (110) and the electrical connector (130) with the first encapsulation material (140) comprises:
arranging at least the selective portions of the power semiconductor die (140) and the electrical connector (130) inside a temporary frame (400),
dispensing a liquid or powdery precursor (200) of the first encapsulation material (140) into the temporary frame (400), such that the precursor (200) is held in place by the temporary frame (400),
curing the precursor (200) in order to form the first encapsulation material (140), and
removing the temporary frame (400).

8. The method (600) of claim 7, wherein the temporary frame (400) comprises built in curing means (430) for curing the precursor (200).

9. The method (600) of one of claims 1 to 6, wherein the interior volume (151) of the housing (150) is divided by dividing walls (510) into at least a first compartment (520) and a second compartment (530),
wherein the first encapsulation material (140) is arranged within the first compartment (520) but not within the second compartment (530).

10. The method (600) of claim 9, wherein the first compartment (520) comprises a part of the module (500) with a comparatively higher operating temperature and the second compartment (530) comprises a part of the module (500) with a comparatively lower operating temperature.

11. The method (600) of one of the preceding claims, wherein the power semiconductor die (110) and the power substrate (120) are enclosed with the housing (150) after at least the selective portions of the power semiconductor die (110) and the electrical connector (130) have been covered with the first encapsulation material (140).

12. The method (600) of one of the preceding claims, further comprising:
after at least the selective portions of the power semiconductor die (110) and the electrical connector (130) have been covered with the first encapsulation material (140), arranging the power substrate (120) on a baseplate, and
coupling the housing (150) to the baseplate.

13. The method (600) of one of the preceding claims, wherein the first encapsulation material (140) comprises or consists of an inorganic silicone and filler particles, the filler particles being from the group containing Al₂O₃, BN, AlN, Si₃N₄ and diamond.

14. A power semiconductor module (500), comprising:
a power semiconductor die (110) arranged on a power substrate (120),
an electrical connector (130) electrically connecting the power semiconductor die (110) to the power substrate (120),
a first encapsulation material (140) covering at least selective portions of the power semiconductor die (110) and the electrical connector (130),
a housing (150) enclosing the power semiconductor die (110) and the power substrate (120), wherein an interior volume (151) formed by the housing (150) is divided by dividing walls (510) into at least a first compartment (520) and a second compartment (530), and
a second encapsulation material (160) arranged on the first encapsulation material (140), such that the first and second encapsulation materials (140, 160) at least partially fill the interior volume (151),
wherein the first encapsulation material (140) exhibits a higher thermostability than the second encapsulation material (160), and
wherein the first encapsulation material (140) is arranged within the first compartment (520) but not within the second compartment (530).

15. The power semiconductor module (500) of claim 14, wherein the first compartment (520) comprises a part of the module (500) with a comparatively higher operating temperature and the second compartment (530) comprises a part of the module (500) with a comparatively lower operating temperature.
